# EUROPEAN PATENT APPLICATION

(11) **EP 4 701 392 A2**
(43) Date of publication of application: **25.02.2026**
(21) Application number: 25197213.9
(22) Date of filing: 21.08.2025
(51) Int. Cl.: H10N 30/00, H10N 30/20, H10N 30/853, H10N 30/078, H10N 30/079

(54) **PIEZOELECTRIC ELEMENT, LIQUID EJECTION HEAD, AND PRINTER**

(30) Priority: 23.08.2024 JP 2024143266
(71) Applicant: Seiko Epson Corporation, Tokyo 160-8801 (JP)
(72) Inventor: YANO, Yoshiki, Suwa-shi, 392-8502 (JP); OHASHI, Koji, Suwa-shi, 392-8502 (JP); NAGANO, Daisuke, Suwa-shi, 392-8502 (JP)
(74) Representative: Lewis Silkin LLP

(57) **Abstract**

A piezoelectric element (100) includes a substrate (10), a first electrode (20) including an adhesion layer (22) which is disposed on the substrate and contains titanium and a conductive layer (24) disposed on the adhesion layer, a diffusion suppression layer (30) which is disposed on the first electrode and is configured to suppress diffusion of the titanium, a piezoelectric layer (50) which is disposed on the diffusion suppression layer and contains potassium, sodium, and niobium, and a second electrode (60) disposed on the piezoelectric layer, wherein the diffusion suppression layer covers an upper surface (20a) and a side surface (20b) of the first electrode.

## Description

The present application is based on, and claims priority from JP Application Serial Number 2024-143266, filed August 23, 2024, the disclosure of which is hereby incorporated by reference herein in its entirety.

### BACKGROUND

### 1. Technical Field

The present disclosure relates to a piezoelectric element, a liquid ejection head, and a printer.

### 2. Related Art

A piezoelectric element used in a liquid ejection head or the like of an inkjet printer is configured by, for example, sandwiching, with two electrodes, a piezoelectric layer made of a piezoelectric material exhibiting an electromechanical conversion function.

For example, JP-A-2023-136545 describes a piezoelectric element including an adhesion layer which is formed on a substrate and contains titanium, a lower electrode formed on the adhesion layer, a diffusion suppression layer formed on the lower electrode, a seed layer formed on the diffusion suppression layer, a piezoelectric layer which is formed on the seed layer and contains potassium, sodium, and niobium, and an upper electrode formed on the piezoelectric layer.

JP-A-2023-136545 is an example of the related art.

In such a piezoelectric element including the potassium sodium niobate (KNN)-based piezoelectric layer as described above, when a titanium layer is used as the adhesion layer, titanium becomes apt to diffuse into the piezoelectric layer due to heat treatment or the like in a manufacturing process. When titanium diffuses, growth of the crystal grains of KNN oriented in a plane other than a (100) plane progresses in addition to original crystal grains of KNN which are preferentially oriented in the (100) plane. Therefore, when the piezoelectric layer is formed with a relatively large thickness, internal stress is apt to concentrate on crystal grain boundaries due to a difference in shrinkage factor, and there is a possibility of a crack occurring in the piezoelectric layer.

In JP-A-2023-136545, although a diffusion suppression layer that suppresses the diffusion of titanium is provided, there is a possibility of titanium diffusing into the piezoelectric layer from a portion not covered with the diffusion suppression layer to generate a crack.

### SUMMARY

An aspect of a piezoelectric element according to the present disclosure includes
a substrate,
a first electrode including an adhesion layer which is disposed on the substrate and contains titanium and a conductive layer disposed on the adhesion layer,
a diffusion suppression layer which is disposed on the first electrode and is configured to suppress diffusion of the titanium,
a piezoelectric layer which is disposed on the diffusion suppression layer and contains potassium, sodium, and niobium, and
a second electrode disposed on the piezoelectric layer, wherein
the diffusion suppression layer covers an upper surface and a side surface of the first electrode.

An aspect of a piezoelectric element according to the present disclosure includes
a substrate,
a first electrode including an adhesion layer disposed on the substrate and a conductive layer disposed on the adhesion layer,
a piezoelectric layer which is disposed on the first electrode and contains potassium, sodium, and niobium, and
a second electrode disposed on the piezoelectric layer, wherein
the adhesion layer is formed of a metal oxide which does not contain titanium.

An aspect of a liquid ejection head according to the present disclosure includes
the piezoelectric element.

An aspect of a printer according to the present disclosure includes
the liquid ejection head.

### BRIEF DESCRIPTION OF THE DRAWINGS

FIG. 1 is a cross-sectional view schematically showing a piezoelectric element according to a first embodiment.
FIG. 2 is a cross-sectional view schematically showing a manufacturing process of the piezoelectric element according to the first embodiment.
FIG. 3 is a cross-sectional view schematically showing a piezoelectric element according to a modified example of the first embodiment.
FIG. 4 is a cross-sectional view schematically showing a piezoelectric element according to a second embodiment.
FIG. 5 is an exploded perspective view schematically showing a liquid ejection head according to a third embodiment.
FIG. 6 is a plan view schematically showing a liquid ejection head according to a third embodiment.
FIG. 7 is a cross-sectional view schematically showing the liquid ejection head according to the third embodiment.
FIG. 8 is a perspective view schematically showing a printer according to a fourth embodiment.
FIG. 9 is a table showing a result of a first experiment.
FIG. 10 is a STEM image of Practical Example 1.
FIG. 11 is a STEM image of Practical Example 1.
FIG. 12 is a STEM image of Comparative Example 1.
FIG. 13 is a table showing a result of a second experiment.

### DESCRIPTION OF EMBODIMENTS

Some preferred embodiments according to the present disclosure will hereinafter be described in detail using the drawings. Note that the embodiments described below do not unreasonably limit the content of the present disclosure set forth in the appended claims. Further, it is not necessarily true that all the configurations to be described below are essential elements of the present disclosure.

### 1. First Embodiment

### 1.1. Piezoelectric Element

### 1.1.1. Configuration

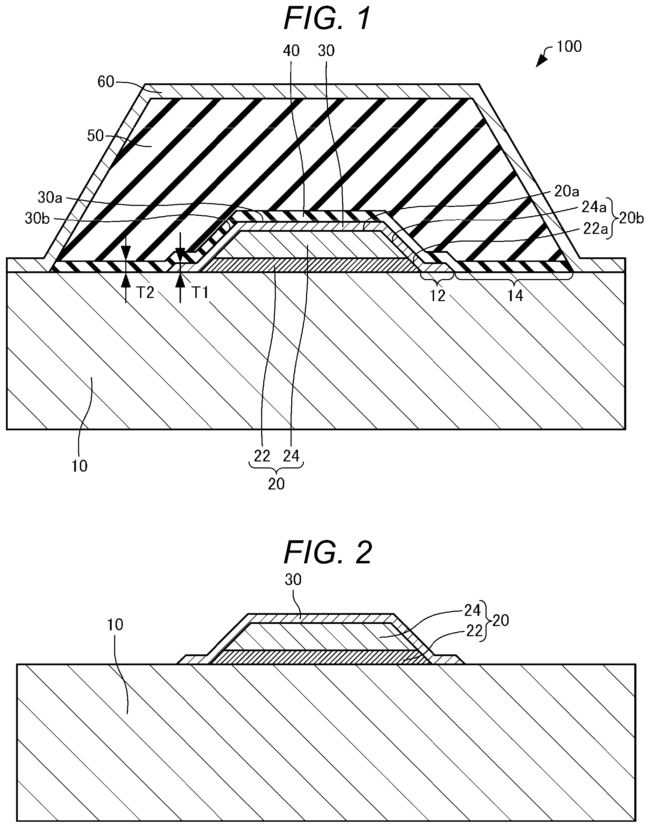

First, a piezoelectric element according to a first embodiment will be described with reference to the drawings. FIG. 1 is a cross-sectional view schematically showing a piezoelectric element 100 according to the first embodiment.

As illustrated in FIG. 1, the piezoelectric element 100 includes, for example, a substrate 10, a first electrode 20, a diffusion suppression layer 30, an orientation control layer 40, a piezoelectric layer 50, and a second electrode 60.

The substrate 10 is a flat plate formed of, for example, a semiconductor or an insulator. The substrate 10 may be a single layer or may be a laminated body having a plurality of layers stacked on one another. An internal structure of the substrate 10 is not limited as long as an upper surface has a planar shape, and may have a structure in which a space or the like is formed inside.

The substrate 10 may include a vibrating plate that is deformed by an action of the piezoelectric layer 50. Examples of the vibrating plate include a silicon oxide layer, a zirconium oxide layer, and a laminated body thereof.

The substrate 10 includes, for example, a first region 12 and a second region 14. The first region 12 is in contact with the diffusion suppression layer 30. The first region 12 surrounds, for example, the first electrode 20 in plan view. The second region 14 is in contact with the orientation control layer 40. A distance between the second region 14 and the first electrode 20 is longer than the distance between the first region 12 and the first electrode 20. The second region 14 surrounds, for example, the first region 12 and the first electrode 20 in plan view.

The first electrode 20 is disposed on the substrate 10. The first electrode 20 is disposed between the substrate 10 and the diffusion suppression layer 30. The shape of the first electrode 20 is a layered shape. The first electrode 20 has, for example, a tapered shape. The thickness of the first electrode 20 is, for example, 10 nm or more and 300 nm or less, and preferably 50 nm or more and 200 nm or less.

Note that in the description related to the present disclosure, a term "on" is used as, for example, "a specific object (hereinafter referred to as "B") is formed "on" another specific object (hereinafter referred to as "A")". In the description related to the present disclosure, in such a case as this example, the term "on" is used to include when B is formed directly on A and when B is formed on A via another object.

The first electrode 20 is one of electrodes for applying a voltage to the piezoelectric layer 50. The first electrode 20 is, for example, a lower electrode disposed at a lower side of the piezoelectric layer 50. The first electrode 20 includes an adhesion layer 22 and a conductive layer 24.

The adhesion layer 22 is disposed on the substrate 10. The adhesion layer 22 is disposed between the substrate 10 and the conductive layer 24. The thickness of the adhesion layer 22 is, for example, 5 nm or more and 40 nm or less, and preferably 10 nm or more and 30 nm or less. The adhesion layer 22 contains titanium. The adhesion layer 22 is, for example, a titanium layer or a titanium oxide layer. The adhesion layer 22 improves adhesion between the first electrode 20 and the substrate 10.

The conductive layer 24 is disposed on the adhesion layer 22. The conductive layer 24 is disposed between the adhesion layer 22 and the diffusion suppression layer 30. The thickness of the conductive layer 24 is larger than the thickness of the adhesion layer 22. The thickness of the conductive layer 24 is, for example, 10 nm or more and 200 nm or less, and preferably 50 nm or more and 150 nm or less. The resistivity of the conductive layer 24 is lower than the resistivity of the adhesion layer 22. The conductive layer 24 is, for example, a platinum layer, an iridium layer, or a laminated body thereof.

The diffusion suppression layer 30 is disposed on the first electrode 20. The diffusion suppression layer 30 is disposed between the first electrode 20 and the orientation control layer 40. The diffusion suppression layer 30 covers an upper surface 20a and side surfaces 20b of the first electrode 20. In the illustrated example, the side surface 20b of the first electrode 20 is formed of a side surface 22a of the adhesion layer 22 and a side surface 24a of the conductive layer 24. The side surface 20b is inclined with respect to an upper surface of the substrate 10. The diffusion suppression layer 30 is further disposed on the first region 12 of the substrate 10.

The thickness T1 of the diffusion suppression layer 30 is, for example, 5 nm or more and 20 nm or less, and preferably 10 nm or more and 20 nm or less. In the illustrated example, the thickness T1 is the thickness on the substrate 10 of the diffusion suppression layer 30. The thickness T1 is measured by, for example, a scanning electron microscope (SEM) or a transmission electron microscope (TEM). The diffusion suppression layer 30 is, for example, an iridium layer, an iridium oxide layer, or a hafnium oxide layer. When the diffusion suppression layer 30 is the iridium layer, the diffusion suppression layer 30 has electrical conductivity. The diffusion suppression layer 30 suppresses diffusion of titanium contained in the adhesion layer 22 into the piezoelectric layer 50.

The orientation control layer 40 is disposed on the diffusion suppression layer 30. In the illustrated example, the orientation control layer 40 is further disposed on the second region 14 of the substrate 10. The orientation control layer 40 is disposed between the diffusion suppression layer 30 and the piezoelectric layer 50. The orientation control layer 40 covers an upper surface 30a and side surfaces 30b of the diffusion suppression layer 30.

The thickness T2 of the orientation control layer 40 is, for example, 5 nm or more and 30 nm or less, and preferably 10 nm or more and 25 nm or less. In the illustrated example, the thickness T2 is the thickness on the substrate 10 of the orientation control layer 40. The thickness T2 is measured by, for example, SEM or TEM. The orientation control layer 40 contains, for example, a complex oxide having a perovskite-type structure containing bismuth (Bi), iron (Fe), titanium (Ti), and lead (Pb). The orientation control layer 40 is, for example, a bismuth ferrite lead titanate ((Bi, Pb)(Fe, Ti)O₃:BFTP) layer. The orientation control layer 40 may be a BFTP layer with an additive. The orientation control layer 40 controls the orientation of the piezoelectric layer 50. Specifically, the orientation control layer 40 orients the piezoelectric layer 50 in the (100) plane.

The piezoelectric layer 50 is disposed on the orientation control layer 40. The piezoelectric layer 50 is disposed on the diffusion suppression layer 30 via the orientation control layer 40. The piezoelectric layer 50 is disposed between the orientation control layer 40 and the second electrode 60. The thickness of the piezoelectric layer 50 is, for example, 100 nm or more and 3000 nm or less, and preferably 500 nm or more and 2000 nm or less. The piezoelectric layer 50 is deformed by applying a voltage between the first electrode 20 and the second electrode 60.

The piezoelectric layer 50 contains, for example, a complex oxide having a perovskite-type structure containing potassium (K), sodium (Na), and niobium (Nb). The piezoelectric layer 50 is a potassium sodium niobate ((K,Na)NbO₃: KNN) layer. A composition of the perovskite-type structure of the piezoelectric layer 50 may be a stoichiometric composition or may be different from the stoichiometric composition. The same applies to the orientation control layer 40. The piezoelectric layer 50 may be a KNN layer with an additive. Examples of the additive include lithium (Li), manganese (Mn), and copper (Cu). The content of the additive is, for example, 10 mol% or less, and preferably 5 mol% or less.

The second electrode 60 is disposed on the piezoelectric layer 50. In the illustrated example, the second electrode 60 covers an upper surface and side surfaces of the piezoelectric layer 50. Further, the second electrode 60 is disposed on the substrate 10. The shape of the second electrode 60 is a layered shape. The thickness of the second electrode 60 is, for example, 15 nm or more and 300 nm or less.

The second electrode 60 is, for example, a platinum layer, a titanium layer, an iridium layer, or a laminated body thereof. The second electrode 60 is another of the electrodes for applying the voltage to the piezoelectric layer 50. The second electrode 60 is, for example, an upper electrode disposed at an upper side of the piezoelectric layer 50.

### 1.1.2. Functions and Advantages

The piezoelectric element 100 includes the substrate 10, the first electrode 20 having the adhesion layer 22 containing titanium and disposed on the substrate 10 and the conductive layer 24 disposed on the adhesion layer 22, the diffusion suppression layer 30 disposed on the first electrode 20 and suppressing the diffusion of titanium, the piezoelectric layer 50 disposed on the diffusion suppression layer 30 and containing potassium, sodium, and niobium, and the second electrode 60 disposed on the piezoelectric layer 50. The diffusion suppression layer 30 covers the upper surface 20a and the side surfaces 20b of the first electrode 20.

Therefore, in the piezoelectric element 100, the diffusion suppression layer 30 can prevent the titanium contained in the adhesion layer 22 from diffusing into the piezoelectric layer 50. Accordingly, it is possible to reduce the possibility of a crack occurring in the piezoelectric layer 50.

In the piezoelectric element 100, the side surface 20b of the first electrode 20 includes the side surface 22a of the adhesion layer 22 and the side surface 24a of the conductive layer 24. Therefore, the adhesion layer 22 and the conductive layer 24 can be collectively patterned. Accordingly, it is possible to achieve shortening of the manufacturing process. Furthermore, since the side surface 22a of the adhesion layer 22 is covered with the diffusion suppression layer 30, the diffusion of titanium from the side surface 22a to the piezoelectric layer 50 can be suppressed by the diffusion suppression layer 30.

The piezoelectric element 100 includes the orientation control layer 40 that is disposed between the diffusion suppression layer 30 and the piezoelectric layer 50 and controls the orientation of the piezoelectric layer 50, and the orientation control layer 40 covers the upper surface 30a and the side surfaces 30b of the diffusion suppression layer 30. Therefore, in the piezoelectric element 100, even when the titanium contained in the adhesion layer 22 is supposedly segregated at an end portion of the first electrode 20, the orientation control layer 40 can be prevented from lifting by the diffusion suppression layer 30 pressing the orientation control layer 40. Accordingly, it is possible to suppress the occurrence of a crack in the piezoelectric layer 50 due to the lift of the orientation control layer 40. The segregated titanium turns to titanium oxide in a firing process to thereby cause volume expansion, and unless the diffusion suppression layer is provided, the orientation control layer lifts due to that volume expansion, and a crack may occur in the piezoelectric layer in some cases. Note that the lift of the orientation control layer will be described later in detail. Further, the "end portion of the first electrode 20" is a boundary between the first electrode 20 and the substrate 10 in plan view.

In the piezoelectric element 100, the diffusion suppression layer 30 is further disposed on the substrate 10, and the substrate 10 has the first region 12 in contact with the diffusion suppression layer 30. Therefore, in the piezoelectric element 100, the lift of the orientation control layer 40 can more effectively be suppressed by the diffusion suppression layer 30.

In the piezoelectric element 100, the diffusion suppression layer 30 has electrical conductivity, the orientation control layer 40 is further disposed on the substrate 10, and the substrate 10 has the second region 14 in contact with the orientation control layer 40. In the piezoelectric element 100, since the diffusion suppression layer 30 having electrical conductivity is not disposed on the second region 14, an electric field between the diffusion suppression layer 30 and the second electrode 60 can accordingly be reduced, and the piezoelectric element 100 can be driven with high accuracy.

In the piezoelectric element 100, the adhesion layer 22 is a titanium oxide layer. Therefore, in the piezoelectric element 100, it is possible to suppress the volume expansion due to the transformation of the titanium layer into the titanium oxide layer, and it is possible to more effectively prevent the orientation control layer 40 from lifting.

In the piezoelectric element 100, the thickness T1 of the diffusion suppression layer 30 is 5 nm or more and 20 nm or less. Therefore, in the piezoelectric element 100, it is possible to suppress a decrease in displacement amount due to an excessively large thickness T1 while suppressing the diffusion of titanium contained in the adhesion layer 22 into the piezoelectric layer 50.

In the piezoelectric element 100, the thickness T2 of the orientation control layer 40 is 5 nm or more and 30 nm or less. Therefore, in the piezoelectric element 100, it is possible to suppress a decrease in crystallinity of the piezoelectric layer 50 due to an excessively large thickness T2 while controlling the orientation of the piezoelectric layer 50.

### 1.2. Method of Manufacturing Piezoelectric Element

Then, a method of manufacturing the piezoelectric element 100 according to the first embodiment will be described with reference to the drawings. FIG. 2 is a cross-sectional view schematically showing a manufacturing process of the piezoelectric element 100 according to the first embodiment.

As shown in FIG. 2, the substrate 10 is prepared. Specifically, a silicon oxide layer is formed by performing thermal oxidation of a silicon substrate. Subsequently, a zirconium layer is formed on the silicon oxide layer using a sputtering method or the like, and then a zirconium oxide layer is formed by thermally oxidizing the zirconium layer. The substrate 10 can be prepared in the steps described above.

Then, the adhesion layer 22 and the conductive layer 24 are formed on the substrate 10 to form the first electrode 20. The adhesion layer 22 and the conductive layer 24 are formed by, for example, a sputtering method or a vacuum vapor deposition method. Then, the first electrode 20 is patterned by, for example, photolithography and etching. The etching is dry etching or wet etching.

Then, the diffusion suppression layer 30 is formed on the first electrode 20 and the substrate 10. The diffusion suppression layer 30 is formed by, for example, a sputtering method or a vacuum vapor deposition method. Subsequently, the diffusion suppression layer 30 is patterned by, for example, photolithography and etching.

As shown in FIG. 1, the orientation control layer 40 is formed on the diffusion suppression layer 30 and the substrate 10. The orientation control layer 40 is formed by, for example, a chemical solution deposition (CSD) method such as a sol-gel method or metal organic deposition (MOD).

Specifically, first, a precursor solution is prepared by dissolving or dispersing a metal complex containing bismuth, a metal complex containing iron, a metal complex containing titanium, and a metal complex containing lead in an organic solvent. Then, the precursor solution is applied onto the first electrode 20 by a spin coating method to form a precursor layer. Then, the precursor layer is heated at a temperature of, for example, 130°C or higher and 250°C or lower and dried for a certain period of time, and the precursor layer thus dried is further heated at a temperature of, for example, 300°C or higher and 450°C or lower and held for a certain period of time to thereby be degreased. Then, the precursor layer thus degreased is crystallized by firing at a temperature of, for example, 550°C or higher and 800°C or lower. In this way, the orientation control layer 40 formed of the BFTP layer can be formed.

Then, the piezoelectric layer 50 is formed on the orientation control layer 40. The piezoelectric layer 50 is formed by, for example, a CSD method.

Specifically, first, for example, a metal complex containing potassium, a metal complex containing sodium, and a metal complex containing niobium are dissolved or dispersed in an organic solvent to prepare a precursor solution.

Examples of the metal complex containing potassium include potassium 2-ethylhexanoate and potassium acetate. Examples of the metal complex containing sodium include sodium 2-ethylhexanoate and sodium acetate. The metal complex containing niobium includes niobium 2-ethylhexanoate. Examples of the solvent include 2-ethylhexanoic acid, decane, and a mixed solvent thereof.

Then, the precursor solution thus prepared is applied onto the orientation control layer 40 by a spin coating method or the like to form a precursor layer. Then, the precursor layer is heated at a temperature of, for example, 130°C or higher and 250°C or lower and dried for a certain period of time, and the precursor layer thus dried is further heated at a temperature of, for example, 300°C or higher and 450°C or lower and held for a certain period of time to thereby be degreased. Then, the precursor layer thus degreased is crystallized by firing at a temperature of, for example, 550°C or higher and 800°C or lower.

In this way, a crystal layer made of a KNN layer can be formed. Then, the series of processes from the application of the precursor solution to the firing of the precursor layer described above are repeated a plurality of times. Thus, the piezoelectric layer 50 formed of a plurality of crystal layers can be formed.

In the process of forming the piezoelectric layer 50, a heating apparatus used for drying and degreasing the precursor layer is, for example, a hot plate. A heating apparatus used for firing the precursor layer is an infrared lamp annealing (rapid thermal annealing: RTA) apparatus.

Subsequently, the piezoelectric layer 50 is patterned by, for example, photolithography and etching. Then, the second electrode 60 is formed on the piezoelectric layer 50 and the substrate 10. The second electrode 60 is formed by, for example, a sputtering method or vacuum vapor deposition.

Due to the processes described above, the piezoelectric element 100 can be manufactured.

### 1.3. Modified Example of Piezoelectric Element

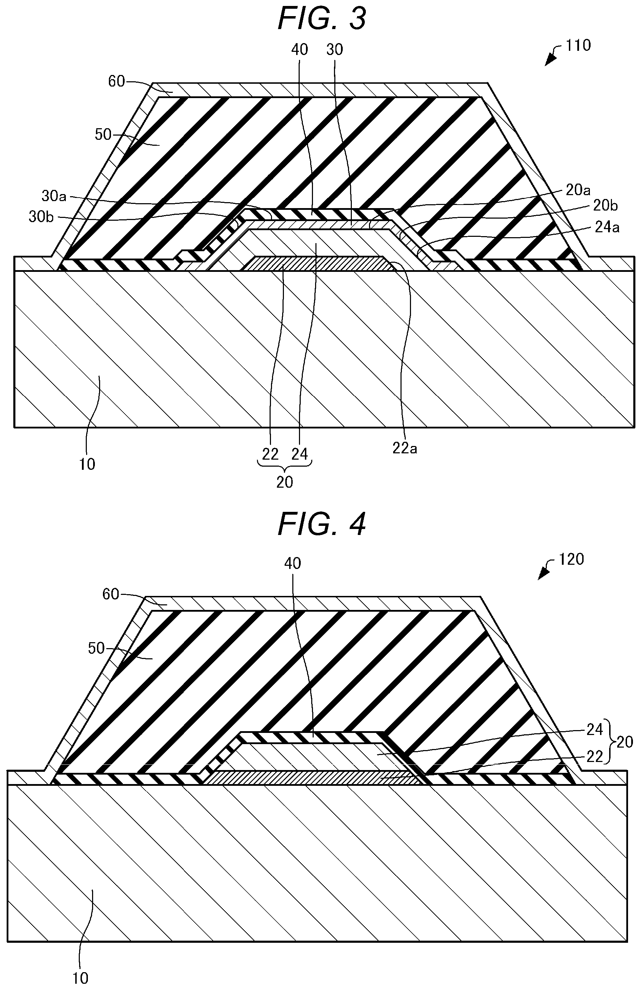

Then, a piezoelectric element according to a modified example of the first embodiment will be described with reference to the drawings. FIG. 3 is a cross-sectional view schematically showing a piezoelectric element 110 according to the modified example of the first embodiment. Hereinafter, in the piezoelectric element 110 according to the modified example of the first embodiment, the members having substantially the same functions as the configuration members of the piezoelectric element 100 according to the first embodiment described above are denoted by the same reference symbols and the detailed descriptions thereof will be omitted.

In the piezoelectric element 100 described above, as illustrated in FIG. 1, the side surface 20b of the first electrode 20 is formed of the side surface 22a of the adhesion layer 22 and the side surface 24a of the conductive layer 24.

In contrast, in the piezoelectric element 110, as shown in FIG. 3, the side surface 20b of the first electrode 20 is formed of the side surface 24a of the conductive layer 24. The side surface 20b of the first electrode 20 is not formed of the adhesion layer 22. The width of the adhesion layer 22 is smaller than the width of the conductive layer 24. The side surface 22a of the adhesion layer 22 is covered with the conductive layer 24. In the method for manufacturing the piezoelectric element 110, the adhesion layer 22 is patterned before the conductive layer 24 is formed on the adhesion layer 22.

In the piezoelectric element 110, similarly to the piezoelectric element 100, the diffusion suppression layer 30 can reduce the possibility of a crack occurring in the piezoelectric layer 50 due to the diffusion of titanium into the piezoelectric layer 50.

### 2. Second Embodiment

### 2.1. Piezoelectric Element

Then, a piezoelectric element according to a second embodiment will be described with reference to the drawings. FIG. 4 is a cross-sectional view schematically showing a piezoelectric element 120 according to the second embodiment. Hereinafter, in the piezoelectric element 120 according to the second embodiment, the members having substantially the same functions as the configuration members of the piezoelectric element 100 according to the first embodiment described above are denoted by the same reference symbols and the detailed descriptions thereof will be omitted.

As shown in FIG. 1, the piezoelectric element 100 described above includes the diffusion suppression layer 30.

In contrast, as shown in FIG. 4, the piezoelectric element 120 does not include the diffusion suppression layer 30. The orientation control layer 40 is disposed on the first electrode 20. The piezoelectric layer 50 is disposed on the first electrode 20 via the orientation control layer 40. The adhesion layer 22 is formed of a metal oxide which does not contain titanium. The adhesion layer 22 is, for example, a hafnium oxide layer or an aluminum oxide layer.

In the piezoelectric element 120, since the adhesion layer 22 is formed of the metal oxide which does not contain titanium, it is possible to reduce the possibility of a crack occurring in the piezoelectric layer 50 due to the diffusion of titanium into the piezoelectric layer 50.

### 2.2. Method of Manufacturing Piezoelectric Element

Then, a method of manufacturing the piezoelectric element 120 according to the second embodiment will be described. The method of manufacturing the piezoelectric element 120 according to the second embodiment is basically the same as the method of manufacturing the piezoelectric element 100 according to the first embodiment described above except that the diffusion suppression layer 30 is not formed. Therefore, the detailed description thereof will be omitted.

### 3. Third Embodiment

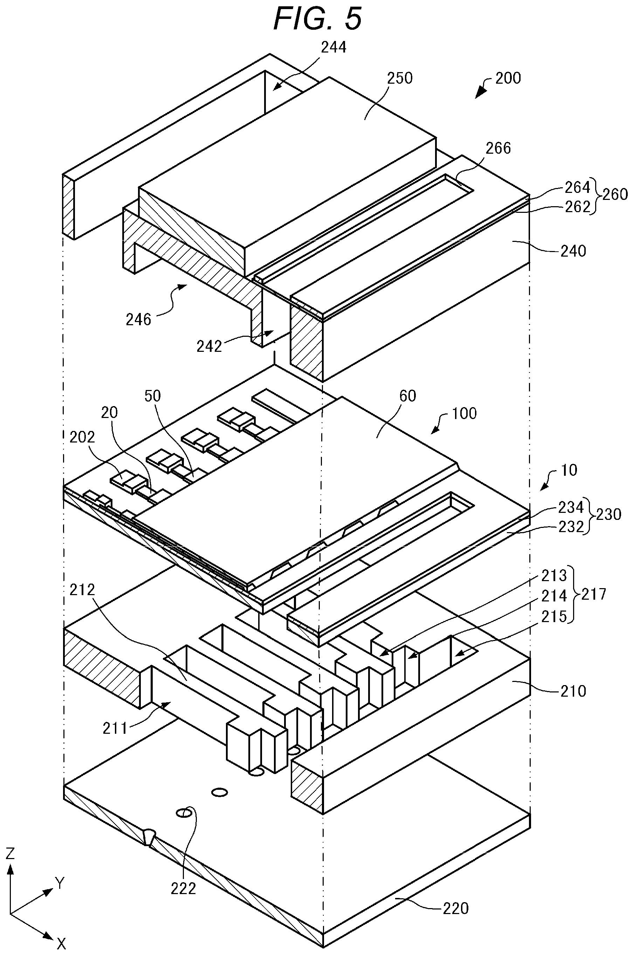

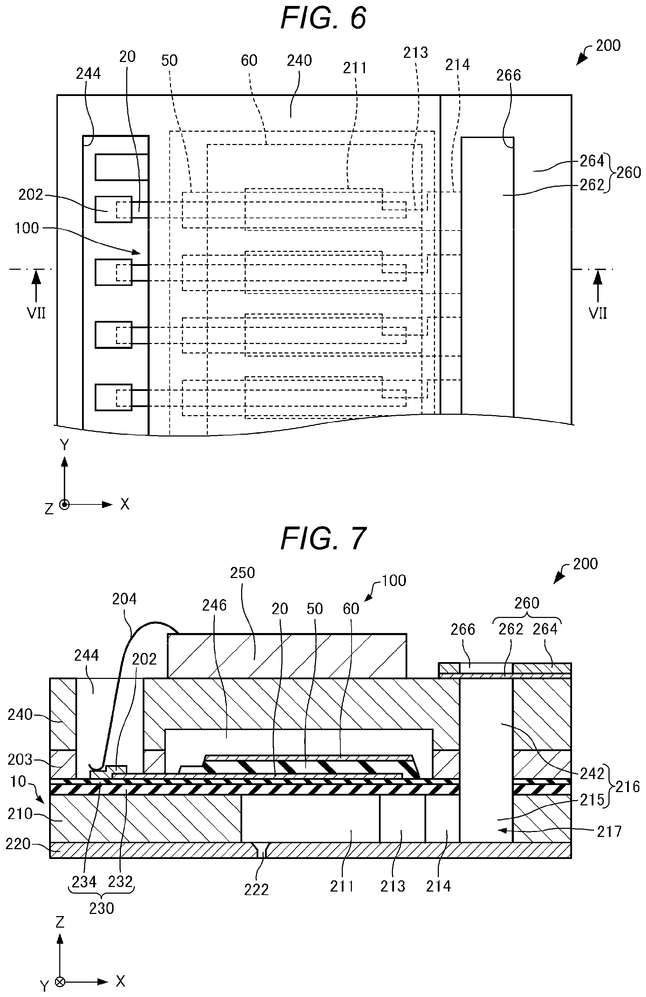

Then, a liquid ejection head according to a third embodiment will be described with reference to the drawings. FIG. 5 is an exploded perspective view schematically showing a liquid ejection head 200 according to the third embodiment. FIG. 6 is a plan view schematically showing the liquid ejection head 200 according to the third embodiment. FIG. 7 is a cross-sectional view along the line VII-VII in FIG. 6, schematically showing the liquid ejection head 200 according to the third embodiment. Note that FIGS. 5 to 7 show an X axis, a Y axis, and a Z axis as three axes orthogonal to each another. Further, in FIGS. 5 and 7, the piezoelectric element 100 is illustrated in a simplified manner, and the diffusion suppression layer 30 and the orientation control layer 40 are not illustrated.

As shown in FIGS. 5 to 7, the liquid ejection head 200 includes, for example, the piezoelectric element 100, a nozzle plate 220, a protective substrate 240, a circuit board 250, and a compliance substrate 260. The substrate 10 includes a channel formation substrate 210 and a vibrating plate 230. Note that in FIG. 6, illustration of the circuit board 250 is omitted for the sake of convenience.

The channel formation substrate 210 is, for example, a silicon substrate. Pressure generation chambers 211 are formed in the channel formation substrate 210. The pressure generation chambers 211 are partitioned by a plurality of partition walls 212. The volume of the pressure generation chamber 211 is changed by the piezoelectric element 100.

A first communication path 213 and a second communication path 214 are provided to an end portion at a +X-axis direction side of the pressure generation chamber 211 in the channel formation substrate 210. The first communication path 213 is configured so that the opening area thereof is reduced by narrowing, from the Y-axis direction, the end portion in the +X-axis direction of the pressure generation chamber 211. The size in the Y-axis direction of the second communication path 214 is the same as, for example, the size in the Y-axis direction of the pressure generation chamber 211. A third communication path 215 communicating with the plurality of second communication paths 214 is formed at the +X-axis direction side of the second communication paths 214. The third communication path 215 forms a part of a manifold 216. The manifold 216 serves as a liquid chamber common to the pressure generation chambers 211. As described above, the channel formation substrate 210 is provided with a supply channel 217 including the first communication paths 213, the second communication paths 214, and the third communication path 215, and the pressure generation chambers 211. The supply channel 217 communicates with the pressure generation chambers 211 and supplies a liquid to the pressure generation chambers 211.

The nozzle plate 220 is disposed on a surface at one side of the channel formation substrate 210. The material of the nozzle plate 220 is, for example, steel use stainless (SUS). The nozzle plate 220 is bonded to the channel formation substrate 210 with, for example, an adhesive or a heat-welded film. A plurality of nozzle holes 222 is provided to the nozzle plate 220 formed along the Y axis. The nozzle hole 222 communicates with the pressure generation chamber 211 to eject the liquid.

The vibrating plate 230 is disposed on a surface at the other side of the channel formation substrate 210. The vibrating plate 230 includes, for example, a silicon oxide layer 232 disposed on the channel formation substrate 210 and a zirconium oxide layer 234 disposed on the silicon oxide layer 232.

The laminated body including the first electrode 20, the piezoelectric layer 50, and the second electrode 60 is disposed on, for example, the vibrating plate 230. A plurality of laminated bodies is provided.

In the liquid ejection head 200, the vibrating plate 230 and the first electrode 20 are displaced by deformation of the piezoelectric layer 50 having electromechanical conversion characteristics. That is, in the liquid ejection head 200, the vibrating plate 230 and the first electrode 20 substantially have a function as a vibrating plate. Note that it is possible to arrange that the vibrating plate 230 is omitted, and only the first electrode 20 functions as the vibrating plate. When the first electrode 20 is directly disposed on the channel formation substrate 210, it is preferable to protect the first electrode 20 with an insulating protective film or the like so that the first electrode 20 is not brought into contact with the liquid.

The first electrode 20 is formed as individual electrodes independent of each other for each pressure generation chamber 211. The size in the Y-axis direction of the first electrode 20 is smaller than the size in the Y-axis direction of the pressure generation chamber 211. The size in the X-axis direction of the first electrode 20 is larger than the size in the X-axis direction of the pressure generation chamber 211. In the X-axis direction, both end portions of the first electrode 20 are located outside both end portions of the pressure generation chamber 211. A lead electrode 202 is coupled to an end portion in the -X-axis direction of the first electrode 20.

The size in the Y-axis direction of the piezoelectric layer 50 is larger than, for example, the size in the Y-axis direction of the first electrode 20. The size in the X-axis direction of the piezoelectric layer 50 is larger than, for example, the size in the X-axis direction of the pressure generation chamber 211. An end portion in the +X-axis direction of the piezoelectric layer 50 is located outside, for example, an end portion in the +X-axis direction of the first electrode 20. The end portion in the +X-axis direction of the first electrode 20 is covered with the piezoelectric layer 50. On the other hand, an end portion in the -X-axis direction of the piezoelectric layer 50 is located inside, for example, the end portion in the -X-axis direction of the first electrode 20. The end portion in the -X-axis direction of the first electrode 20 is not covered with the piezoelectric layer 50.

For example, the second electrode 60 is disposed continuously on the piezoelectric layer 50 and the vibrating plate 230. The second electrodes 60 adjacent to each other are continuous with each other and are configured as a common electrode.

The protective substrate 240 is bonded to the channel formation substrate 210 with an adhesive 203. A through hole 242 is provided to the protective substrate 240. In the illustrated example, the through hole 242 penetrates the protective substrate 240 in a Z-axis direction and communicates with the third communication path 215. The through hole 242 and the third communication path 215 form the manifold 216 serving as the liquid chamber common to the pressure generation chambers 211. Further, the protective substrate 240 is provided with a through hole 244 that penetrates the protective substrate 240 in the Z-axis direction. End portions of the lead electrodes 202 are located in the through hole 244.

An opening portion 246 is provided to the protective substrate 240. The opening portion 246 is a space for preventing the drive of the piezoelectric element 100 from being hindered. The opening portion 246 may be sealed but is not required to be sealed.

The circuit board 250 is disposed on the protective substrate 240. The circuit board 250 includes a semiconductor integrated circuit (IC) for driving the piezoelectric element 100. The circuit board 250 and the lead electrode 202 are electrically coupled via a coupling wire 204.

The compliance substrate 260 is disposed on the protective substrate 240. The compliance substrate 260 includes a sealing layer 262 disposed on the protective substrate 240 and a fixing plate 264 disposed on the sealing layer 262. The sealing layer 262 is a layer for sealing the manifold 216. For example, the sealing layer 262 has flexibility. A through hole 266 is provided to the fixing plate 264. The through hole 266 penetrates the fixing plate 264 in the Z-axis direction. The through hole 266 is disposed at a position overlapping the manifold 216 viewed from the Z-axis direction.

### 4. Fourth Embodiment

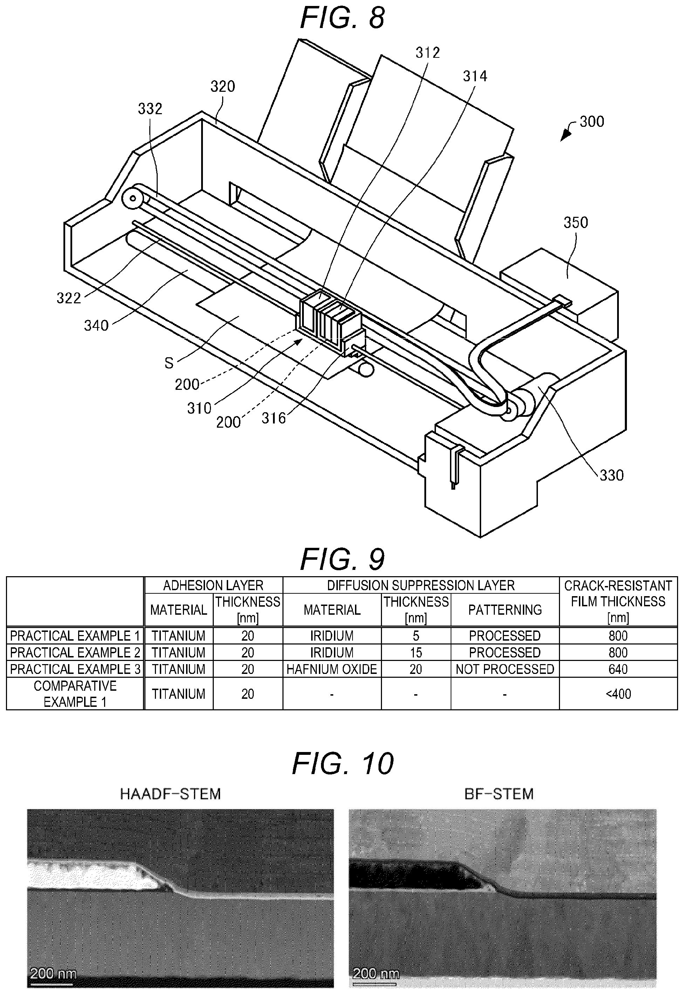

Then, a printer according to a fourth embodiment will be described with reference to the drawings. FIG. 8 is a perspective view schematically showing a printer 300 according to the fourth embodiment.

The printer 300 is an inkjet printer. As shown in FIG. 6, the printer 300 includes a head unit 310. The head unit 310 includes, for example, the liquid ejection heads 200. The number of liquid ejection heads 200 is not particularly limited. To the head unit 310, cartridges 312 and 314 forming a supply unit are detachably attached. A carriage 316 on which the head unit 310 is mounted is disposed on a carriage shaft 322 which is attached to an apparatus main body 320 so as to be movable in axial directions, and ejects the liquid supplied from the supply unit of the liquid.

Here, the liquid is only required to be a material in a state in which a substance is in a liquid phase, and includes a material in a liquid state such as sol or gel. Further, the liquid includes not only a liquid as one state of a substance, but also a liquid with particles of a solid functional material such as pigments or metal particles dissolved, dispersed, or mixed in a solvent. Representative examples of the liquid include ink and liquid crystal emulsion. The ink includes various types of liquid compositions such as general water-based ink, oil-based ink, gel ink, and hot-melt ink.

In the printer 300, by a driving force of a drive motor 330 being transmitted to the carriage 316 via a plurality of gears (not shown) and a timing belt 332, the carriage 316 on which the head unit 310 is mounted is moved along the carriage shaft 322. Meanwhile, the apparatus main body 320 is provided with a conveyance roller 340 as a conveyance mechanism for moving a sheet S as a target recording medium such as paper relatively to the liquid ejection heads 200. The conveyance mechanism that conveys the sheet S is not limited to the conveyance roller, but may be a belt, a drum, or the like.

The printer 300 includes a printer controller 350 as a controller that controls the liquid ejection heads 200 and the conveyance roller 340. The printer controller 350 is electrically coupled to the circuit board 250 of the liquid ejection heads 200. The printer controller 350 includes, for example, a random access memory (RAM) that temporarily stores various types of data, a read only memory (ROM) that stores control programs and the so on, a central processing unit (CPU), and a drive signal generation circuit that generates drive signals to be supplied to the liquid ejection heads 200.

Note that the piezoelectric element 100 can be used in a wide range of applications besides the liquid ejection head and the printer. The piezoelectric element 100 is preferably used as a piezoelectric actuator of, for example, an ultrasonic motor, a vibrating dust removal device, a piezoelectric transformer, a piezoelectric speaker, a piezoelectric pump, and a pressure-electricity conversion device. Further, the piezoelectric element 100 is preferably used as a piezoelectric-type sensor element of, for example, an ultrasonic detector, an angular velocity sensor, an acceleration sensor, a vibration sensor, a tilt sensor, a pressure sensor, a collision sensor, a human sensor, an infrared sensor, a terahertz sensor, a heat detection sensor, a pyroelectric sensor, and a piezoelectric sensor. Further, the piezoelectric element 100 is preferably used as a ferroelectric element such as a ferroelectric memory (FeRAM), a ferroelectric transistor (FeFET), a ferroelectric calculation circuit (FeLogic), and a ferroelectric capacitor. In addition, the piezoelectric element 100 is preferably used as a voltage-controlled optical element of a wavelength converter, an optical waveguide, an optical path modulator, a refractive index control element, an electronic shutter mechanism, and so on.

### 5. Practical Examples and Comparative Examples

### 5.1. First Experiment

### 5.1.1. Sample Preparation

### Practical Example 1

A silicon oxide layer having a thickness of 1460 nm was formed by thermally oxidizing a surface of a single crystal silicon substrate. Then, a zirconium layer having a thickness of 400 nm was formed by a direct current (DC) sputtering method, and then a zirconium oxide layer was formed by heat treatment at 850°C.

Then, a titanium layer having a thickness of 20 nm as an adhesion layer, a platinum layer having a thickness of 80 nm as a conductive layer, and an iridium layer having a thickness of 5 nm were formed on the zirconium oxide layer by a DC sputtering method to thereby form the first electrode. Then, the first electrode was patterned by photolithography and etching.

Then, an iridium layer having a thickness of 5 nm was formed as the diffusion suppression layer on the first electrode by a DC sputtering method. Then, the diffusion suppression layer was patterned by photolithography and etching.

Then, a BFTP precursor solution was prepared so as to have a molar ratio of Bi:Pb:Fe:Ti=110:10:50:50. Then, the BFTP precursor solution thus prepared was applied onto the diffusion suppression layer by a spin coating method, dried at 180°C for 3 minutes, degreased at 380°C for 3 minutes, and fired at 650°C for 3 minutes. In this way, the BFTP layer having a thickness of 20 nm was formed as the orientation control layer.

Then, simple solutions respectively containing potassium 2-ethylhexanoate, sodium 2-ethylhexanoate, and niobium 2-ethylhexanoate were each synthesized. A mixed solvent of 2-ethylhexanoic acid and decane was used as a solvent. These simple solutions were mixed to obtain (K_{0.50}Na_{0.50})_{1.015}NbOₓ (where x is any number larger than 0) to thereby obtain a KNN precursor solution.

Then, the KNN precursor solution thus prepared was applied onto the BFTP layer by a spin coating method, dried at 180°C for 3 minutes, degreased at 380°C for 3 minutes, and fired at 700°C for 3 minutes. A heating rate for firing was set to 10°C/sec. In this way, a crystal layer having a thickness of 80 nm was formed. Then, by repeating the series of steps from the application of the KNN precursor solution to the firing of the KNN precursor layer, the KNN layer as the piezoelectric layer was formed.

In this way, a sample in Practical Example 1 was prepared.

### Practical Example 2

A sample in Practical Example 2 was produced with substantially the same method as in Practical Example 1 except that the thickness of the iridium layer as the diffusion suppression layer was set to 15 nm.

### Practical Example 3

A sample in Practical Example 3 was prepared with substantially the same method as in Practical Example 1 except that a hafnium oxide layer having a thickness of 20 nm was used as the diffusion suppression layer and the diffusion suppression layer was not patterned.

### Comparative Example 1

A sample in Comparative Example 1 was prepared with substantially the same method as in Practical Example 1 except that the diffusion suppression layer was not formed.

### 5.1.2. Evaluation Result

On the samples in Practical Examples 1 to 3 and Comparative Example 1, presence or absence of a crack in the piezoelectric layer at the end portion of the first electrode was observed. The observation was performed with "Digital Microscope VHX-X1" manufactured by Keyence Corporation.

FIG. 9 is a table showing a result of a first experiment. As shown in FIG. 9, in Practical Examples 1, 2, the crystal layer was successfully laminated without generating a crack up to the thickness of the piezoelectric layer of 800 nm. In Practical Example 3, the crystal layer was successfully laminated without generating a crack up to the thickness of the piezoelectric layer of 640 nm. In Comparative Example 1, a crack was generated at the thickness of the piezoelectric layer smaller than 400 nm.

From the above, it was found out that the crack in the piezoelectric layer can be prevented by the diffusion suppression layer.

On the samples in Practical Example 1 and Comparative Example 1, the scanning transmission electron microscope (STEM) observation of a cross-section sectioned by a focused ion beam (FIB) was performed. For the STEM observation, "Talos F200X" manufactured by Thermo Fisher Scientific was used.

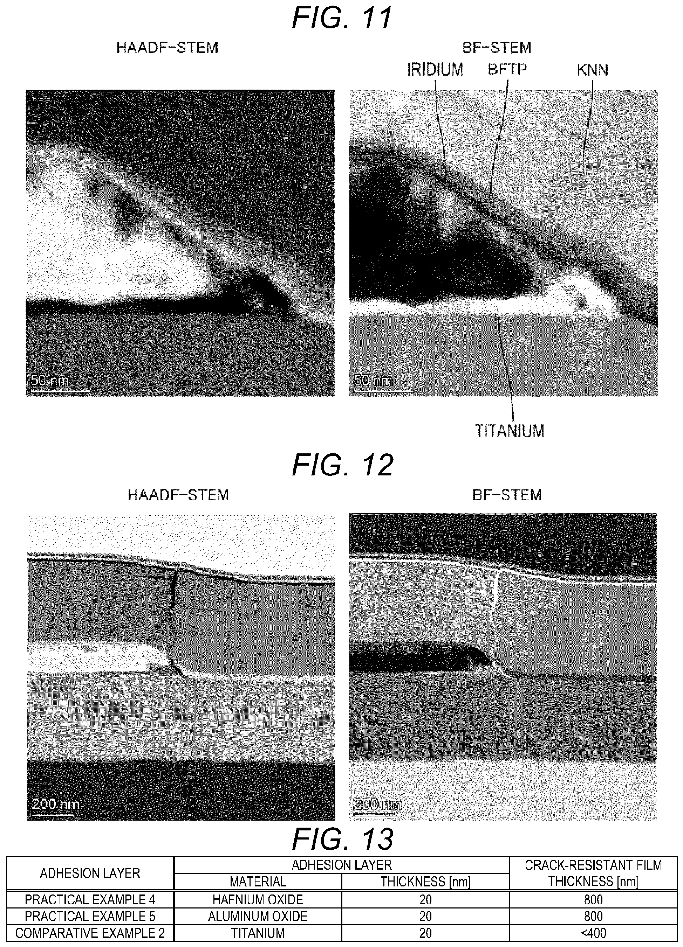

FIG. 10 is a STEM image of Practical Example 1. FIG. 11 is an enlarged view in the vicinity of an end portion of the first electrode in FIG. 10. FIG. 12 is a STEM image of Comparative Example 1. FIGS. 10 to 12 illustrate a High Angle Annular Dark Field (HAADF)-STEM image and a Bright Field (BF)-STEM image.

As shown in FIG. 10, in Practical Example 1, no crack was generated in the KNN layer. As shown in FIG. 11, in Practical Example 1, Ti in the adhesion layer was segregated at the end portion to cause the volume expansion, but a lift of the BFTP layer was not observed.

As shown in FIG. 12, in Comparative Example 1, a crack was generated in the KNN layer at the end portion of the first electrode. In Comparative Example 1, it was observed that titanium in the adhesion layer was segregated at the end portion to cause volume expansion, and the BFTP layer was lifted.

From the above, it was found out that the lift of the BFTP layer was successfully suppressed by the diffusion suppression layer.

### 5.2. Second Experiment

### 5.2.1. Sample Preparation

### Practical Example 4

A silicon oxide layer having a thickness of 1460 nm was formed by thermally oxidizing a surface of a single crystal silicon substrate. Then, a zirconium layer having a thickness of 400 nm was formed by a DC sputtering method, and then a zirconium oxide layer was formed by heat treatment at 850°C.

Then, a hafnium oxide layer having a thickness of 20 nm as an adhesion layer, a platinum layer having a thickness of 80 nm as a conductive layer, and an iridium layer having a thickness of 5 nm were formed on the zirconium oxide layer by a DC sputtering method to thereby form the first electrode. Then, the first electrode was patterned by photolithography and etching.

Then, the BFTP layer and the KNN layer were sequentially formed. A method of forming the BFTP layer and the KNN layer is the same as the formation method in Practical Example 1.

In this way, a sample in Practical Example 4 was prepared.

### Practical Example 5

A sample in Practical Example 5 was prepared with substantially the same method as in Practical Example 4 except that an aluminum oxide layer was used as the adhesion layer.

### Comparative Example 2

A sample in Comparative Example 2 was prepared with substantially the same method as in Practical Example 4 except that a titanium layer was used as the adhesion layer.

### 5.2.2. Evaluation Result

On the samples in Practical Examples 4, 5 and Comparative Example 2, presence or absence of a crack in the piezoelectric layer at the end portion of the first electrode was observed in substantially the same manner as in the first experiment described above.

FIG. 13 is a table showing a result of the second experiment. As shown in FIG. 13, in Practical Examples 4, 5, the crystal layer was successfully laminated without generating a crack up to the thickness of the piezoelectric layer of 800 nm. On the other hand, in Comparative Example 2, a crack was generated at the thickness of the piezoelectric layer smaller than 400 nm.

From the above, it was found out that a crack in the piezoelectric layer was successfully suppressed by using, as the adhesion layer, a metal oxide layer which does not contain titanium.

The embodiments and modified examples described above are illustrative only, and the present disclosure is not limited thereto. For example, it is possible to appropriately combine the embodiments and the modified examples with each other.

The present disclosure includes substantially the same configurations as the configurations described in the embodiments, such as a configuration having the same function, method, and result, or a configuration having the same object and advantage. Further, the present disclosure includes a configuration in which a non-essential part of the configurations described in the embodiments is replaced. Further, the present disclosure includes a configuration that achieves the same function and advantage or a configuration that can achieve the same object as in the configurations described in the embodiments. Further, the present disclosure includes a configuration obtained by adding a known technique to the configurations described in the embodiments.

The following configurations are derived from the embodiments and modified examples described above.

An aspect of a piezoelectric element includes
a substrate,
a first electrode including an adhesion layer which is disposed on the substrate and contains titanium and a conductive layer disposed on the adhesion layer,
a diffusion suppression layer which is disposed on the first electrode and is configured to suppress diffusion of the titanium,
a piezoelectric layer which is disposed on the diffusion suppression layer and contains potassium, sodium, and niobium, and
a second electrode disposed on the piezoelectric layer, wherein
the diffusion suppression layer covers an upper surface and a side surface of the first electrode.

According to this piezoelectric element, it is possible to reduce the possibility of a crack being generated in the piezoelectric layer.

In the aspect of the piezoelectric element,
the side surface of the first electrode may be formed of a side surface of the adhesion layer and a side surface of the conductive layer.

According to this piezoelectric element, shortening of the manufacturing process can be achieved.

In the aspect of the piezoelectric element, there may further be provided
an orientation control layer that is disposed between the diffusion suppression layer and the piezoelectric layer and is configured to control an orientation of the piezoelectric layer, wherein
the orientation control layer may cover an upper surface and a side surface of the diffusion suppression layer.

According to this piezoelectric element, it is possible to suppress the lift of the orientation control layer.

In the aspect of piezoelectric element,
the diffusion suppression layer may be further disposed on the substrate, and
the substrate may have a first region in contact with the diffusion suppression layer.

According to this piezoelectric element, the lift of the orientation control layer can more effectively be suppressed.

In the aspect of the piezoelectric element,
the diffusion suppression layer may have electrical conductivity,
the orientation control layer may be further disposed on the substrate, and
the substrate may have a second region in contact with the orientation control layer.

According to this piezoelectric element, an electric field between the diffusion suppression layer and the second electrode can be reduced, and the piezoelectric element can accurately be driven.

In the aspect of the piezoelectric element,
the adhesion layer may be a titanium oxide layer.

According to this piezoelectric element, the lift of the orientation control layer can more effectively be suppressed.

In the aspect of the piezoelectric element,
a thickness of the diffusion suppression layer may be 5 nm or more and 20 nm or less.

According to this piezoelectric element, it is possible to suppress a decrease in displacement amount due to an excessively large thickness of the diffusion suppression layer while suppressing the diffusion of titanium contained in the adhesion layer into the piezoelectric layer.

In the aspect of the piezoelectric element,
a thickness of the orientation control layer may be 5 nm or more and 30 nm or less.

According to this piezoelectric element, it is possible to suppress a decrease in crystallinity of the piezoelectric layer due to an excessively large thickness of the orientation control layer while controlling the orientation of the piezoelectric layer.

An aspect of a piezoelectric element includes
a substrate,
a first electrode including an adhesion layer disposed on the substrate and a conductive layer disposed on the adhesion layer,
a piezoelectric layer which is disposed on the first electrode and contains potassium, sodium, and niobium, and
a second electrode disposed on the piezoelectric layer, wherein
the adhesion layer is formed of a metal oxide which does not contain titanium.

According to this piezoelectric element, it is possible to reduce the possibility of a crack being generated in the piezoelectric layer.

An aspect of a liquid ejection head includes
the aspect of the piezoelectric element.

An aspect of a printer includes
the liquid ejection head.

## Claims

1. A piezoelectric element comprising:
a substrate;
a first electrode including an adhesion layer which is disposed on the substrate and contains titanium and a conductive layer disposed on the adhesion layer;
a diffusion suppression layer which is disposed on the first electrode and is configured to suppress diffusion of the titanium;
a piezoelectric layer which is disposed on the diffusion suppression layer and contains potassium, sodium, and niobium; and
a second electrode disposed on the piezoelectric layer, wherein
the diffusion suppression layer covers an upper surface and a side surface of the first electrode.

2. The piezoelectric element according to claim 1, wherein
the side surface of the first electrode is formed of a side surface of the adhesion layer and a side surface of the conductive layer.

3. The piezoelectric element according to claim 1, further comprising
an orientation control layer that is disposed between the diffusion suppression layer and the piezoelectric layer and is configured to control an orientation of the piezoelectric layer, wherein
the orientation control layer covers an upper surface and a side surface of the diffusion suppression layer.

4. The piezoelectric element according to claim 3, wherein
the diffusion suppression layer is further disposed on the substrate, and
the substrate has a first region in contact with the diffusion suppression layer.

5. The piezoelectric element according to claim 4, wherein
the diffusion suppression layer has electrical conductivity,
the orientation control layer is further disposed on the substrate, and
the substrate has a second region in contact with the orientation control layer.

6. The piezoelectric element according to claim 1, wherein
the adhesion layer is a titanium oxide layer.

7. The piezoelectric element according to claim 1, wherein
a thickness of the diffusion suppression layer is 5 nm or more and 20 nm or less.

8. The piezoelectric element according to claim 3, wherein
a thickness of the orientation control layer is 5 nm or more and 30 nm or less.

9. A piezoelectric element comprising:
a substrate;
a first electrode including an adhesion layer disposed on the substrate and a conductive layer disposed on the adhesion layer;
a piezoelectric layer which is disposed on the first electrode and contains potassium, sodium, and niobium; and
a second electrode disposed on the piezoelectric layer, wherein
the adhesion layer is formed of a metal oxide which does not contain titanium.

10. A liquid ejection head comprising the piezoelectric element according to claim 1.

11. A printer comprising the liquid ejection head according to claim 10.
